# EUROPÄISCHE PATENTANMELDUNG

(11) **EP 0 632 491 A2**
(43) Veröffentlichungstag der Anmeldung: **04.01.1995**
(21) Anmeldenummer: 94109102.7
(22) Anmeldetag: 14.06.1994
(51) Int. Cl.: H01L 21/331, H01L 29/735

(54) **Herstellungsverfahren für lateralen Bipolartransistor**

(30) Priorität: 02.07.1993 DE 4322138
(71) Anmelder: SIEMENS AKTIENGESELLSCHAFT, D-80333 München (DE)
(72) Erfinder: Bertagnolli, Emmerich, Dr., D-80799 München (DE); Klose, Helmut, Dr., D-81929 München (DE)

(57) **Zusammenfassung**

Herstellungsverfahren für lateralen Bipolartransistor, bei dem unter Verwendung einer Maske durch Implantation in einen mit einer Grunddotierung versehenen Bereich (4) in der Siliziumschicht eines SOI-Substrates eine hoch dotierte Emitterzone (7) und Kollektorzone (8) sowie eine Basisanschlußzone ausgebildet werden und dann unter Verwendung einer Maske (10) eine Basiszone zwischen dieser Emitterzone (7) und dieser Kollektorzone (8) durch Implantieren von Dotierstoff hergestellt wird.

## Beschreibung

Bei integrierten Bipolartransistoren ist eine vertikal übereinander angeordnete Schichtfolge für Emitter, Basis und Kollektor üblich. In dieser Vertikalanordnung sind jeweils zwei Zonen der Schichtfolge nicht direkt, d. h. von der Oberfläche her, zugänglich, sondern müssen seitlich verlängert und anschließend an die Oberfläche geführt werden. Für die unterste dotierte Schicht ist im allgemeinen noch eine weitere, hoch dotierte vergrabene Schicht notwendig, um die Zuleitung zur Oberfläche ausreichend niederohmig zu halten. Der eigentliche Transistor, d. h. die npn-Folge bzw. die pnp-Folge der Schichten, wird nicht fotolithographisch, sondern durch Diffusionsprozesse und Implantationen bestimmt, so daß Dimensionen im Sub-µm-Bereich problemlos erreichbar sind. Der Nachteil dieser Anordnung ist, daß vertikale Transistoren eine merkliche Tiefenausdehnung, typischerweise 1 bis 2 µm, und laterale Abmessungen haben, die den eigentlichen Transistorbereich um ein Vielfaches übertreffen. Entsprechend gibt es eine Reihe von parasitären Kapazitäten und Widerständen, die neben der möglichen Einbuße bei der Schaltgeschwindigkeit vor allem den Leistungsbedarf deutlich erhöhen. Daneben ist die Komplexität des Herstellungsprozesses und der Flächenbedarf dieser Bauelemente verglichen mit MOS-Bauelementen sehr hoch und führt zu niedrigen Ausbeuten bei hohen Herstellungskosten. Die gleichzeitige Herstellung komplementärer Strukturen (npn- und pnp-Transistoren) z. B. für analoge Anwendungen ist nur unter erheblichem Aufwand möglich.

Bei lateral angeordneten Bipolartransistoren werden üblicherweise die Bereiche für Emitter und Kollektor in ein größeres Basisgebiet eingebettet, so daß auch diese Transistoren eine relativ große Ausdehnung in der Tiefe besitzen. Ein einfaches Herstellungsverfahren für derartige laterale Transistoren ist bisher nicht bekannt.

Aufgabe der vorliegenden Erfindung ist es, ein einfaches Verfahren anzugeben für die Herstellung von lateralen Bipolartransistoren für Anwendung im Bereich niedrigster Leistung und reduzierter Versorgungsspannungen, wobei dieses Verfahren die Integration von npn- und pnp-Transistoren in einem Bauelement problemlos ermöglichen soll.

Diese Aufgabe wird mit dem Verfahren mit den Verfahrensschritten des Anspruches 1 gelöst. Weitere Ausgestaltungen ergeben sich aus den abhängigen Ansprüchen.

Bei dem erfindungsgemäßen Verfahren werden laterale Bipolartransistoren in einer dünnen Siliziumschicht z. B. eines SOI-Substrates hergestellt. Dabei werden die unterschiedlich dotierten Bereiche für Emitter, Basis und Kollektor durch Implantation von Dotierstoff in eine Grunddotierung unter Verwendung von Masken hergestellt.

Es folgt eine Beschreibung des erfindungsgemäßen Herstellungsverfahrens anhand der Figuren 1 bis 5.
- Fig. 1 bis 3: zeigen einen erfindungsgemäß hergestellten Transistor im Querschnitt nach verschiedenen Schritten des Herstellungsverfahrens.
- Fig. 4: zeigt eine Alternative des Verfahrens im Prozeßschritt der Fig. 2.
- Fig. 5: zeigt den in Fig. 3 eingezeichneten Schnitt.

Bei dem erfindungsgemäßen Verfahren wird vorteilhaft von einem SOI-Substrat (Silicon on insulator) ausgegangen. Statt eines eigentlichen SOI-Substrates kann auch SIMOX-Material oder eine entsprechende durch Wafer-Bonding hergestellte Schichtstruktur verwendet werden. Es kommt nur darauf an, daß eine dünne Nutzschicht aus Silizium auf einem isolierenden Untergrund oder einer isolierenden Zwischenschicht aufgebracht: ist und mit den üblichen Verfahren der Siliziumtechnik bearbeitet werden kann. Das erfindungsgemäße Verfahren eignet sich gleichermaßen für die Herstellung von npn-Transistoren wie für pnp-Transistoren. Um die Beschreibung der Ausführungsbeispiele möglichst konkret zu halten, wird im folgenden die Herstellung eines npn-Transistors beschrieben. Bei pnp-Transistoren sind entsprechend nur die Vorzeichen der Dotierung zu vertauschen.

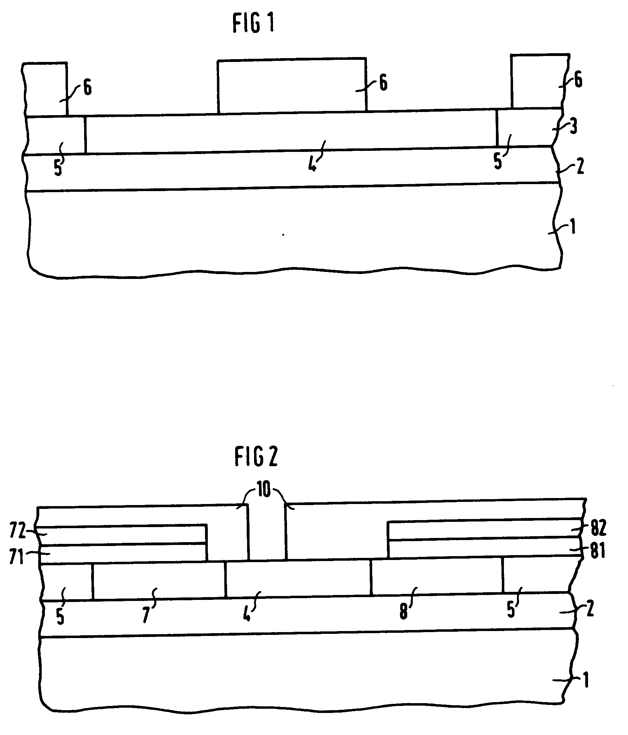

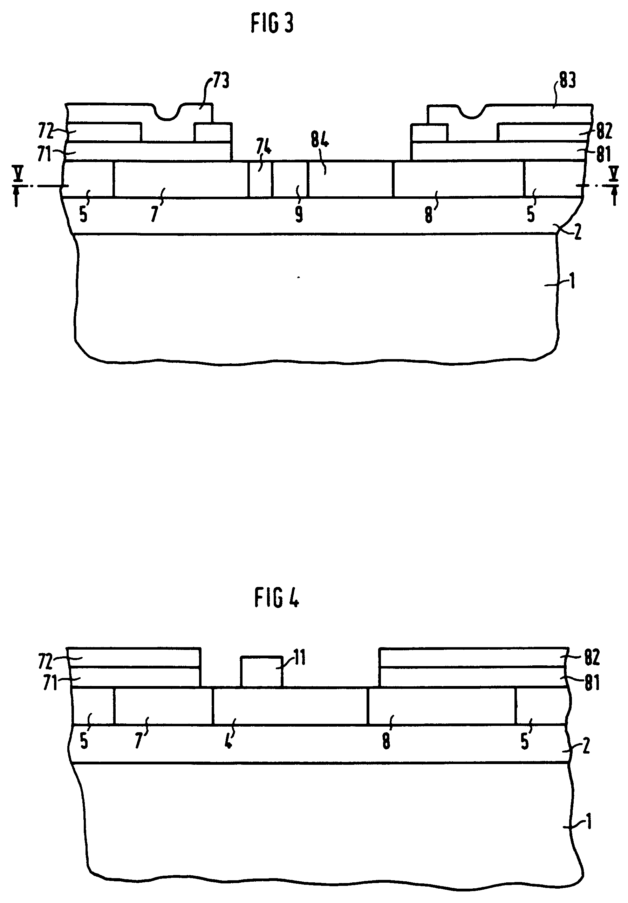

In der Siliziumschicht, die z. B. 2 um bis 20 nm dick sein kann, wird der für den Transistor vorgesehene Bereich lateral ringsum isoliert und mit einer Grunddotierung versehen. Am einfachsten ist es, wenn die Siliziumschicht zu Beginn des Verfahrens bereits mit einer Grunddotierung einer Dichte von etwa 10¹⁵ bis 10¹⁷ cm⁻³ (bei n-Dotierungen Phosphor oder Arsen als Dotierstoff) versehen ist. Die Isolation der Ränder kann z. B. durch LOCOS oder durch Grabenätzung oder dgl. erfolgen, wobei auch eine Kombination dieser Maßnahmen in Frage kommt. In dem Ausführungsbeispiel wird davon ausgegangen, daß laterale Isolationsbereiche mittels LOCOS hergestellt sind. In Fig. 1 sind das Substrat 1, die Isolationsschicht 2 und die Siliziumschicht 3 dargestellt. In der Siliziumschicht 3 sind der mit der Grunddotierung versehene Bereich 4 und die lateralen Isolationsbereiche 5 im Querschnitt dargestellt. Die Isolationsschicht 2 kann z. B. SiO₂ sein. Mittels Fotolithographie und unter Verwendung von damit hergestellten Masken 6 werden Implantierungen von Dotierstoffen für die Anschlußgebiete von Emitter, Kollektor und Basis vorgenommen. Die Höhe der Dotierung wird dabei für einen niederohmigen Metall-Halbleiter-Kontakt für die spätere elektrische Kontaktierung gewählt. Damit ergeben sich die in Fig. 2 dargestellte hoch dotierte Emitter-Zone 7, die gleichzeitig als Emitteranschlußzone vorgesehen ist, und die hoch dotierte Kollektorzone 8, die als Kollektoranschlußzone vorgesehen ist. Die hoch dotierte Basisanschlußzone entgegengesetzten Vorzeichens der Leitfähigkeit befindet sich außerhalb des in Fig. 2 dargestellten Querschnittes. Ebenso wie die Reihenfolge der Herstellung der Grunddotierung und der Isolationsbereiche ist die Reihenfolge der Herstellung der n⁺-dotierten und der p⁺-dotierten Zonen beliebig. p⁺-dotierte Zonen werden z. B. durch Ionenimplantation von Bor als Dotierstoff hergestellt. Ggf. werden die Dotierungen einem Ausheilungs- und/oder Diffusionsprozeß unterzogen (z. B. RTA/FA-Prozesse).

Bei der in Fig. 2 dargestellten vorteilhaften Ausführungsform werden anschließend eine Schicht aus Polysilizium und eine Schicht aus Dielektrikum übereinander abgeschieden. Die Polysiliziumschicht wird entsprechend den anzuschließenden Zonen dotiert und zusammen mit der Dielektrikumschicht strukturiert. Diese Strukturierung erfolgt durch eine Kombination von Fotolithographie und Ätzen. Wenn zusätzlich zu der Emitterzone 7 und der Kollektorzone 8 die Basisanschlußzone kontaktiert werden soll, muß der auf der Basisanschlußzone aufgebrachte Teil der Polysiliziumschicht für elektrische Leitung des entgegengesetzten Vorzeichens dotiert werden. In Fig. 2 sind die durch den entsprechenden Anteil dieser Polysiliziumschicht gebildete Kontaktschicht 71 für die Emitterzone 7, die durch den entsprechenden Anteil dieser Polysiliziumschicht gebildete Kontaktschicht 81 für die Kollektorzone 8 und die darauf befindlichen entsprechenden Anteile der Dielektrikumschicht 72, 82 eingezeichnet. Anschließend wird eine Maske 10, z. B. aus Fotolack, hergestellt (z. B. mittels Fotolithographie oder Elektronenstrahl-Belichtung). Ggf., falls die Lackdichte für eine Blockmaske alleine nicht ausreicht, kann eine Hilfsschicht mit eingesetzt werden, die unter Zuhilfenahme der Maske strukturiert werden kann, z. B. durch einen Ätzschritt. Die eigentliche Blockschicht ist dann entweder die eben beschriebene Schicht oder eine Kombination dieser Schicht mit dem nicht entfernten Lack. Diese Maske 10 wird verwendet, um eine Implantierung von Dotierstoff für den der Grunddotierung entgegengesetzten Leitfähigkeitstyp vorzunehmen. Falls wie in diesem Ausführungsbeispiel die Grunddotierung das gleiche Vorzeichen wie Emitter und Kollektor hat, wird in dem nachfolgenden Schritt die Implantierung der Basiszone 9 (s. Fig. 3) vorgenommen. Die Kontaktschichten 71, 81 und ggf. zugehörigen Dielektrikumschichten 72, 82 können auch erst im Anschluß an die Herstellung der Basiszone 9 aufgebracht und strukturiert werden.

Die Maske 10 wird entfernt und die Dotierung ausgeheilt. Es ergibt sich die Struktur der Fig. 3. Zwischen der Emitterzone 7 und der Basiszone 9 befindet sich noch eine weitere Emitterzone 74 mit dem Vorzeichen der Leitfähigkeit der Emitterzone 7. Zwischen der Basiszone 9 und der Kollektorzone 8 befindet sich eine weitere Kollektorzone 84 mit dem Vorzeichen der Leitfähigkeit der Kollektorzone 8. Statt dessen ist es möglich, die Öffnung der Maske 10 so auszurichten, daß die weitere Emitterzone 74 entfällt und die Emitterzone 7 unmittelbar an die hergestellte Basiszone 9 angrenzt. Der Einheitlichkeit der Bezeichnungsweise der npn- bzw. pnp-Schichten wegen wurde die Zonenfolge in der in diesen Querschnitten dargestellten Richtung als Emitterzone, Basiszone und Kollektorzone bezeichnet. Die Emitterzone 7 und die Kollektorzone 8 sind aber im Gegensatz zu der Basiszone 9 hoch dotiert, während die hoch dotierte Anschlußzone der Basiszone 9 an diese angrenzend lateral außerhalb der Schnittebene angeordnet ist.

Die relative Ausrichtung dieser verschiedenen Zonen zueinander wird anhand der Fig. 5 veranschaulicht. Die Fig. 5 zeigt den Schnitt, der in Fig. 3 bezeichnet ist. Zusätzlich zu den Zonen auf der Höhe der ursprünglichen Siliziumschicht 3 sind gestrichelt die Konturen später aufzubringender Metallisierungen mit eingezeichnet. Der Bereich des Transistors ist rings durch Isolationsbereich 5 umgeben. Die Basiszone 9 ist zwischen der Emitterzone 7 und der Kollektorzone 8 angeordnet. Die ggf. vorhandenen weitere Emitterzone 74 und weitere Kollektorzone 84 mit gegenüber der Emitterzone 7 und der Kollektorzone 8 niedrigeren Dotierungen sind ebenfalls eingezeichnet. Senkrecht zur Verbindungsrichtung zwischen Emitterzone 7 und Kollektorzone 8 befindet sich an die Basiszone 9 angrenzend je eine Basisanschlußzone 19, die hoch dotiert ist. Die Metallkontakte 73, 83, 93 für Emitter, Kollektor bzw. Basis sind mit gestrichelten Konturen eingezeichnet.

Ggf. wird an ein weiteres Dielektrikum deponiert oder gewachsen (z. B. SiO₂ oder Si₃N₄) und unter Zuhilfenahme einer Fototechnik so strukturiert, daß Emitter-, Kollektor- und Basiszonen kontaktiert werden können. Es werden die Kontaktlöcher für Emitter, Basis und Kollektor hergestellt und die entsprechenden Metallisierungen aufgebracht, wobei z. B. TiN/Al(Si, Cu) verwendet werden kann. Es ergibt sich so der Aufbau der Fig. 3, wobei in dieser Fig. 3 die in Blickrichtung vorhandenen Anschlußschichten für die Basisanschlußzone nicht mit eingezeichnet sind.

Bei dem erfindungsgemäßen Verfahren kann die Polysiliziumschicht zur Kontaktierung von Emitter und Kollektor (Kontaktschichten 71, 81) auch ersetzt werden durch W/TiN oder andere hochschmelzende Metalle, Metallverbindungen bzw. Polycide (Verbindungen von Metall mit Polysilizium). In diesem Fall kann die erste Metallisierungsebene vollständig mit diesen Materialien ausgeführt werden, so daß zwei Fotolithographieschritte (Kontaktloch und erste Metallisierungsebene) entfallen.

Bei dem erfindungsgemäßen Verfahren können nach der Herstellung der Emitterzone, der Kollektorzone und der Basisanschlußzone diese auch direkt mit der ersten Metallisierungsebene kontaktiert werden. Nach der Fertigstellung der Diffusionsgebiete (z. B. Implantation und anschließendes Ausheilen) wird ganzflächig ein Dielektrikum abgeschieden und in diesem Dielektrikum Kontaktlöcher geätzt. In diese Kontaktlöcher wird dann die Metallisierung eingebracht.

Ein wichtiger Vorteil dieser erfindungsgemäßen Herstellungsverfahren ist die Möglichkeit, wie in Fig. 3 dargestellt, die Basiszone unsymmetrisch zwischen Emitter und Kollektor zu legen und damit die Durchbruchsspannung geeignet einstellen zu können. Ein weiterer Vorteil ist die Möglichkeit, auf einfache Weise zwischen der hoch dotierten Emitterzone 7 und der Basiszone 9 eine weitere Emitterzone 74 mit dem Leitungstyp der hoch dotierten Emitterzone 7 herzustellen. Das geschieht durch geeignete Anordnung der Maske 10 (s. Fig. 2). Auf diese Weise wird eine Überlappung der hoch dotierten Emitterzone 7 und der Basiszone 9 vermieden. Dadurch können die Abmessung und die Höhe der Dotierung dieser Basiszone 9 und damit der Basis-Bahnwiderstand genauer eingestellt werden, ohne daß das Durchbruchsverhalten zwischen Emitter und Basis und die Emitter-Basis-Kapazität und Leckströme wesentlich verschlechtert werden. Der (absolute) Betrag der Dotierungshöhe dieser weiteren Emitterschicht 74 ist jeweils kleiner als der der Basiszone 9 und der hoch dotierten Emitterzone 7.

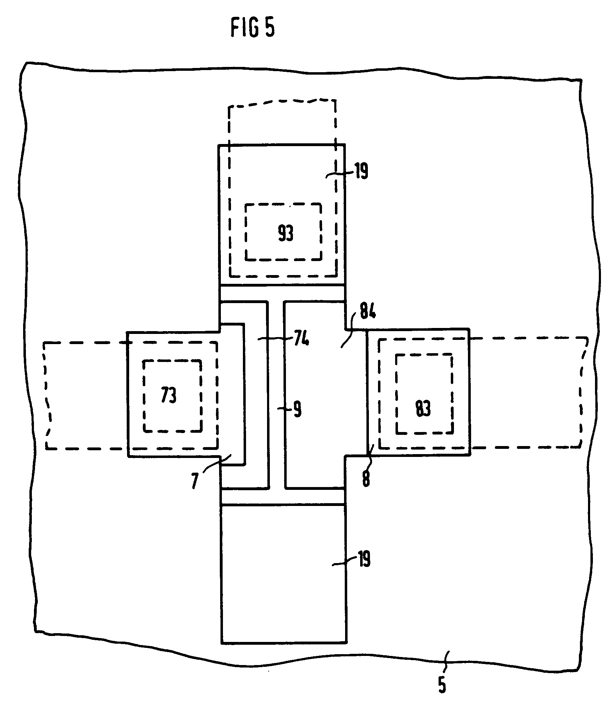

Bei dem erfindungsgemäßen Verfahren kann statt der beschriebenen Grunddotierung auch von einer Grunddotierung entgegengesetzten Leitungstyp ausgegangen werden. Das Vorzeichen dieser Dotierung wird dann entsprechend dem Vorzeichen der Basiszone gewählt. Anstatt in einem Gebiet dieser Grunddotierung durch einen Spalt in einer Maske die Basiszone durch Implantation zu erzeugen, kann, wie in Fig. 4 gezeigt, durch eine Maske 11, die die herzustellende Basiszone abdeckt, eine laterale Implantation zur Umdotierung der Grunddotierung vorgenommen werden. In Fig. 4 ist die stegförmige Maske 11 im Querschnitt auf dem Bereich 4 der Grunddotierung eingezeichnet. Die Höhe der Grunddotierung wird entsprechend der Höhe der herzustellenden Basiszone eingestellt (z. B. 1 x 10¹⁸ cm⁻ ³ bis 4 x 10¹⁸ cm⁻³). Die Maske 11 wird z. B. durch Fotolithographie hergestellt. Die Abmessung in der Ebene der Fig. 4, also von Emitterzone 7 zu Kollektorzone 8 beträgt etwa 30 bis 300 nm. Durch Implantation wird unter Verwendung dieser Maske 11 das Gebiet 4 der Grunddotierung in ein entgegengesetzt dotiertes Gebiet umgewandelt (Dotierungshöhe z. B. 1 x 10¹⁹ cm⁻³ bis 2 x 10²⁰ cm⁻³). Die Emitterzone, Basiszone und Kollektorzone sind damit selbstjustiert hergestellt. Die Kontaktierung erfolgt hierbei in einer der bereits beschriebenen Varianten. Es kann die Metallisierung direkt auf den hoch dotierten Zonen aufgebracht werden oder eine Schichtfolge mit einer untersten Polysiliziumschicht, die entsprechend dotiert wird, vorgesehen werden. Bei allen Herstellungsvarianten ist die Basis senkrecht zur Zeichenebene verlängert und endet in einer Basisanschlußzone, auf der die entsprechende Kontaktierung für den Basisanschluß aufgebracht wird. Auch dieser Anschluß kann direkt durch Metall oder indirekt über eine Polysiliziumschicht erfolgen.

## Patentansprüche

1. Verfahren zur Herstellung eines lateralen Bipolartransistors, bei dem
in einem ersten Schritt in einer Siliziumschicht (3), die sich auf einer Isolationsschicht (2) befindet, ein für einen Transistor vorgesehener Bereich (4) lateral ringsum elektrisch isoliert wird und dieser Bereich (4) mit einer Grunddotierung versehen wird,
in einem zweiten Schritt unter Verwendung von Masken (6) eine hoch dotierte Emitterzone (7), eine hoch dotierte Basisanschlußzone (19) und eine hoch dotierte Kollektorzone (8) durch Implantation von Dotierstoffen hergestellt werden,
in einem dritten Schritt unter Verwendung einer Maske (10; 11) zur Herstellung einer Basiszone (9) eine Implantation von Dotierstoff für den der Grunddotierung entgegengesetzten Leitungstyp vorgenommen wird und
in einem vierten Schritt Metallkontakte (73, 83, 93) für Emitter, Basis und Kollektor aufgebracht werden.

2. Verfahren nach Anspruch 1, bei dem
in dem ersten Schritt die Grunddotierung für den dem Leitungstyp der Basis entgegengesetzten Leitungstyp hergestellt wird und
in dem dritten Schritt die Maske (10) den für die Basiszone (9) vorgesehenen Bereich frei läßt.

3. Verfahren nach Anspruch 1, bei dem
in dem ersten Schritt die Grunddotierung für den Leitungstyp der Basis hergestellt wird und
in dem dritten Schritt die Maske (11) den für die Basiszone (9) vorgesehenen Bereich abdeckt.

4. Verfahren nach einem der Ansprüche 1 bis 3, bei dem
vor dem vierten Schritt auf der Emitterzone (7), auf der Basisanschlußzone (19) und auf der Kollektorzone (8) elektrisch voneinander isolierte Kontaktschichten (71, 81) aus leitfähig dotiertem Polysilizium aufgebracht werden.

5. Verfahren nach Anspruch 4, bei dem
vor dem dritten Schritt die Kontaktschichten (71, 81) aus Polysilizium aufgebracht werden.

6. Verfahren nach einem der Ansprüche 1 bis 5, bei dem
in dem dritten Schritt die Basiszone (9) symmetrisch bezüglich der Emitterzone (7) und der Kollektorzone (8) angeordnet wird und zwischen der Basiszone (9) und der Emitterzone (7) eine niedrig dotierte weitere Emitterzone (74) und zwischen der Basiszone (9) und der Kollektorzone (8) eine niedrig dotierte weitere Kollektorzone (84) mit der Leitfähigkeit der Grunddotierung bleiben.

7. Verfahren nach einem der Ansprüche 1 bis 5, bei dem
in dem dritten Schritt die Basiszone (9) so hergestellt wird, daß sie an die Emitterzone (7) angrenzt und zwischen der Basiszone (9) und der Kollektorzone (8) eine niedrig dotierte weitere Kollektorzone (84) mit dem Leitfähigkeitstyp der Kollektorzone (8) bleibt.
